# EUROPÄISCHE PATENTSCHRIFT

(11) **EP 1 029 107 B1**
(45) Veröffentlichungstag und Bekanntmachung des Hinweises auf die Patenterteilung: **03.04.2002**
(21) Anmeldenummer: 98951149.8
(22) Anmeldetag: 05.11.1998
(51) Int. Cl.: C23C 16/26, C23C 16/02

(54) **VERFAHREN ZUM BESCHICHTEN VON SINTERMETALLCARBID-SUBSTRATEN MIT EINER DIAMANTSCHICHT**
METHOD FOR APPLYING A DIAMOND LAYER ON SUBSTRATES MADE OF SINTERED METALLIC CARBIDE
PROCEDE POUR REVETIR D'UNE COUCHE DE DIAMANT DES SUBSTRATS DE CARBURE METALLIQUE FRITTE

(30) Priorität: 07.11.1997 CH 258097
(43) Veröffentlichungstag der Anmeldung: 23.08.2000
(73) Patentinhaber: Unaxis Trading AG, 9477 Trübbach (CH)
(72) Erfinder: KARNER, Johann, A-6800 Feldkirch (AT); SCHOEB, Wolfgang, CH-9473 Gams (CH)
(74) Vertreter: Troesch Scheidegger Werner AG
(86) Internationale Anmeldenummer: CH9800473
(87) Internationale Veröffentlichungsnummer: WO9924636

(56) Entgegenhaltungen:
- EP-A- 0 519 587
- US-A- 5 700 518
- CAPPELLI E ET AL: "DIAMOND NUCLEATION AND GROWTH ON DIFFERENT CUTTING TOOL MATERIALS: INFLUENCE OF SUBSTRATE PRE-TREATMENTS" DIAMOND AND RELATED MATERIALS, Bd. 5, Nr. 3/05, April 1996, Seiten 292-298, XP000627526 in der Anmeldung erwähnt
- DEUERLER F ET AL: "Pretreatment of substrate surface for improved adhesion of diamond films on hard metal cutting tools" DIAMOND AND RELATED MATERIALS, Bd. 5, Nr. 12, Dezember 1996, Seite 1478-1489 XP004049889 in der Anmeldung erwähnt

## Beschreibung

Die vorliegende Erfindung betrifft ein Verfahren zum Beschichten von Sintermetallcarbid-Substraten mit einer Diamantschicht, bei dem das Substrat vor der Diamantbeschichtung einem Co-selektiven, einem WC-selektiven Ätzschritt und weiter einer Bekeimung durch Reiben mittels Diamantpulver unterzogen wird.

Unter dem Ausdruck "Sintermetall-Carbid" sei ein WC-Sintermetall mit Co-Bindemittel verstanden.

Bezüglich dem Bedürfnis, diamantbeschichtete Sintermetallcarbid-Substrate bereitzustellen sowie der Entwicklung der daraufhin gerichteten: Techniken sei vollumfänglich auf die diesbezüglichen Ausführungen in der DE-OS 19 522 372 verwiesen.

Im Lichte der vorliegenden Erfindung erscheinen folgende Ansätze aus dem Stande der Technik wesentlich:

Aus dem Jahre 1989 ist es, entsprechend der EP 0 374 923, bekannt, nach erfolgter, formgebender Bearbeitung am Substrat, letzteres einer. Temperaturbehandlung zwischen 1'000°C und 1'600°C zu unterwerfen, darnach mittels eines selektiven, chemischen Ätzschrittes Kobalt von der Substratoberfläche zu entfernen. Daraufhin wird die Oberfläche in einem Ultraschallbad aktiviert mittels harter Partikel, wie beispielsweise mittels Diamantpulver. Dann wird, mittels eines CVD-Verfahrens, die Diamantschicht abgeschieden.

Die in dieser Schrift zusammengestellten Resultate zeigen eine deutliche Verbesserung des Verschleissverhaltens des diamantbeschichteten Substrates, jedoch unterschiedslos für die Fälle, in welchen eine Pulverbekeimung erfolgte bzw. nicht erfolgte. Die Unterschiedlichkeit der Resultate basiert auf der Durchführung bzw. Nichtdurchführung der thermischen Behandlung.

Aus dem Jahre 1991 beschreibt die EP 0 519 587 die diesbezüglich vorbekannten Ansätze, u.a. auch denjenigen gemäss der erwähnten EP 0.374 923, nämlich, die Oberfläche des Substrates vor der Diamantbeschichtung "zu polieren oder zu kratzen", geht jedoch dabei nicht darauf ein, wie dieses "Polieren oder Kratzen" erfolgt. Es wird aber ausgeführt, dass es bekannt geworden sei, dass ohne Polieren oder Kratzen keine befriedigende Haftung der Diamantschicht am Sintermetall-Carbidsubstrat erreicht würde.

In dieser Schrift wird nun vorgeschlagen, die Sintermetallcarbid-Substrat-Oberfläche zuerst einem selektiven WC-Ätzschritt zu unterziehen, dann einem zweiten Ätzschritt, welcher den Rest des ersten Ätzschrittes wegätzt. Darnach wird durch ein CVD-oder PECVD-Verfahren der Diamantfilm abgelegt. Bei der Präzisierung des "Rest"-Ätzschrittes wird ausgeführt, es würden die Überbleibsel der Lösung, die für den ersten Ätzschritt eingesetzt wurde sowie ein Teil des Kobalt-Bindemittels im zweiten Ätzschritt entfernt.

Jedenfalls wird die Betonung darauf gelegt, dass die behandelten Substrate nicht poliert werden.

Im Jahre 1995 schliesslich wird in der DE-OS 19 522 372 vorgeschlagen, unterschiedslos polierte oder zerkratzte Sintermetallcarbid-Substrate erst einem selektiven Co-Ätzschritt in einem ersten chemischen System zu unterwerfen, nach Reinigung einem zweiten, selektiven WC-Ätzschritt in einem zweiten chemischen System und dann, nach nochmaliger Reinigung, den Diamantfilm aufzubringen. Es wird dabei befunden, dass die gewünschte Entfernung von Oberflächenkörnchen aus Wolframcarbid durch das erwähnte mehrstufige Ätzverfahren vorgenommen werden könne, und dass der Unterschied, ob die Substrate vorgängig geschliffen bzw. gekratzt wurden, einzig darin liege, dass die WC-Körnchen beschädigt seien und im anderen Falle eben nicht.

Aus der EP-A-500 119 ist es weiter bekannt, ein Sintermetallcarbid-Substrat erst einem Co-Ätzschritt zu unterziehen, dann mit Diamantpulver zu bekeimen und schliesslich mit einer Diamantschicht zu beschichten.

Aus F. Deuerler et al. "Pretreatment of substrate surface for improved adhesion of diamond films on hard metal cutting tools", Diamond and related materials, Band 5, Nr. 12, Dezember 1996, Seiten 1478 - 1489, ist es weiter bekannt, vor dem Diamantpulverbekeimen und dem anschliessenden Diamantbeschichten, Sintermetallcarbid-Substrate entweder und in Analogie zur EP-A-0 374 923 Co-selektiv zu ätzen oder aber WC-selektiv zu ätzen.

Schliesslich ist es aus E. Cappelli et al.: "Diamond nucleation and growth on different cutting tool materials: influence of substrate pre-treatments", Diamond and related materials, Band 5, Nr. 3/05, April 1996, Seiten 292 - 289 bekannt, entweder und in Analogie zu F. Deuerler, vor Diamantpulver-Bekeimung und anschliessender Diamantbeschichtung einen WC-selektiven Ätzschritt vorzunehmen, oder, hinzukommend zum erwähnten, vorgelagerten WC-selektiven Ätzschritt, nach dem Diamantpulverbekeimen einen weiteren, selektiven Ätzschritt, nämlich einen Co-selektiven Ätzschritt, vorzunehmen.

Somit ist es aus der DE-OS-19 522 372 sowie aus E. Cappelli bekannt, als Beschichtungs-Vorbehandlung, sowohl einen Co-selektiven wie auch einen WC-selektiven Ätzschritt vorzunehmen, wobei gemäss der DE-OS-19 522 372 beide Ätzschritte nach dem mechanischen Zerkratzen der Substratoberfläche vorgenommen werden, gemäss E. Cappelli der WC-selektive Ätzschritt vor, der Co-selektive Ätzschritt nach dem zerkratzenden Diamantpulverbekeimen vorgenommen wird.

Die vorliegende Erfindung geht von diesen letzterwähnten Techniken aus. Sie stellt sich zur Aufgabe, ein Verfahren zu schaffen, welches die Diamantschichthaftung am Sintermetallcarbid-Substrat weiter erhöht. Dies wird erfindungsgemäss dadurch erreicht, dass der Co-selektive Ätzschritt und der WC-selektive Ätzschritt vor der Durchführung der Bekeimung mit Diamantpulver und - selbstverständlich - der Diamantbeschichtung vorgenommen wird.

Während nämlich beim Vorgehen gemäss der DE-OS-19 522 372 die dort beschriebenen chemischen Behandlungsverfahren unterschiedslos zu erwünschten Haftverhältnissen der Diamantschicht führen, ob nämlich die Sintercarbid-Substrate mechanisch geschliffen werden oder nicht, und auch die Folgerungen in E. Cappelli zeigen, dass der Diamantpulverbekeimung keine mitentscheidene Rolle bezüglich Haftungsqualität zukommt, wird nun vorliegendenfalls erkannt, dass, in der erfindungsgemäss vorgeschlagenen Schrittabfolge, der erwähnte Bekeimungsschritt zu einer wesentlichen Verbesserung der Diamantschichthaftung führt. Durch die erfindungsgemässe Kombination und Abfolge von Verfahrensschritten wird es gar möglich, die Diamantbeschichtung unabhängig von der mechanischen Vorbehandlung der Substrate haftfest vorzusehen: Es können unbehandelte oder geschliffene oder polierte Substrate nach der erfindungsgemässen Behandlung im wesentlichen mit gleicher Haft-Qualität diamantbeschichtet werden.

In einer bevorzugten Ausführungsform des erfindungsgemässen Verfahrens wird erst der WC-selektive Ätzschritt, dann der Co-selektive Ätzschritt vorgenommen, wobei der Co-selektive Ätzschritt gleichzeitig mit dem Bekeimungsschritt vorgenommen werden kann.

Wie erwähnt, ist es wesentlich, im Rahmen der vorliegenden Erfindung die Diamantpulverbekeimung einerseits, selbstverständlicherweise, vor der Diamantbeschichtung, aber zusätzlich auch nach der WC-selektiven Ätzung und der Co-selektiven Ätzunggegebenenfalls gleichzeitig mit dem zeitlich nachgelagerten dieser Ätzschritte - vorzunehmen. Damit kann das erfindungsgemässe Verfahren wie folgt vorgenommen werden:
- Co-Ätzen
- WC-Ätzen, gegebenenfalls gleichzeitig:
- Diamantpulverbekeimen
- Diamantbeschichten
oder und bevorzugt
- WC-Ätzen
- Co-Ätzen, gegebenenfalls gleichzeitig:
- Diamantpulverbekeimen
- Diamantbeschichten.

Bezüglich der bekannten chemischen Systeme, welche sich einerseits für die selektive WC-Ätzung eignen, anderseits für die selektive Co-Ätzung, kann z.B. auf die DE 19 522 372 verwiesen werden.

Die erwähnten Ätzschritte werden, wie dort ausgeführt, grundsätzlich in flüssigen Chemiesystemen durchgeführt. Die Bekeimung mit Diamantpulver kann dabei trocken erfolgen, beispielsweise durch Beschuss oder durch Reiben mit Diamantpulver, wird aber bevorzugterweise im Ultraschallbad vorgenommen, dabei vorzugsweise gleichzeitig mit demjenigen Ätzschritt vorgenommen, der unmittelbar vor der Diamantbeschichtung ausgeführt wird. Die Behandlung erfolgt durch Ultraschall-Beaufschlagung des entsprechenden, chemischen Ätzflüssigsystems und Einbringen von Diamantpulver in das Ätzbad.

Im folgenden werden die beispielhaft behandelten Sintermetallcarbid-Substrate definiert, die erfindungsgemäss sowie, zu Vergleichszwecken nicht erfindungsgemäss, behandelt wurden. Die Resultate der daran durchgeführten Verschleissverhaltens-Versuche werden anhand von Figuren präsentiert und diskutiert.

### A) den Untersuchungen zugrundegelegte Sintermetallcarbid-Substrate

Typ 3 % (3,5 % Co-Gehalt) :
   Hartmetall-Wendeschneidplatten Sandvik H∅5
   Geometrie: SPGN 120308
Typ 6 %: Hartmetall-Wendeschneidplatten Sandvik H13A
   Geometrie: SPGN 120308

### B) Behandlung

### B.1) Alle erwähnten Substrate wurden wie folgt und in folgender Reihenfolge behandelt:

- WC-Ätzschritt;
- Co-Ätzschritt;
- Bekeimungsschritt;

Bei den als Vergleichsuntersuchungen eingesetzten, nicht bekeimten Wendeschneidplatten wurde lediglich der Bekeimungsschritt weggelassen.

### B.2) Diamantbeschichtung

Die erfindungsgemäss Diamantpulver-bekeimten bzw. die gleich behandelten, aber nicht erfindungsgemäss Diamantpulver-bekeimten Wendeschneidplatten wurden wie folgt getestet:
- Planfräsen
- Gefrästes Material: AlSi20
   - Vorschub:: 0,1 mm pro Umdrehung bzw. pro Zahn (Fräskopf nur mit einem Zahn)
   - Schnittiefe:: 0,5 mm
   - Schnittgeschwindigkeit:: 1200, 1500 bzw. 2000 m/min., Trockenbearbeitung.

### C) Resultate

In Funktion der Fräszeit in Minuten wurde der Freiflächen-Verschleiss gemessen und aufgetragen, d.h. die grösste Ausdehnung der durch kontinuierlichen Diamantschicht-Verschleiss ausgeschliffenen Sintermetallcarbid-Oberflächen. Treten keine Abplatzungen auf, wird der Test bis zum Erreichen einer Verschleissmarkenbreite von 250 µm durchgeführt. Kommt es zu einem Abplatzen der Diamantschicht, wird der freigelegte Hartmetall-Bereich gemessen (steiler Knick der Verschleiss-Kurve nach oben).

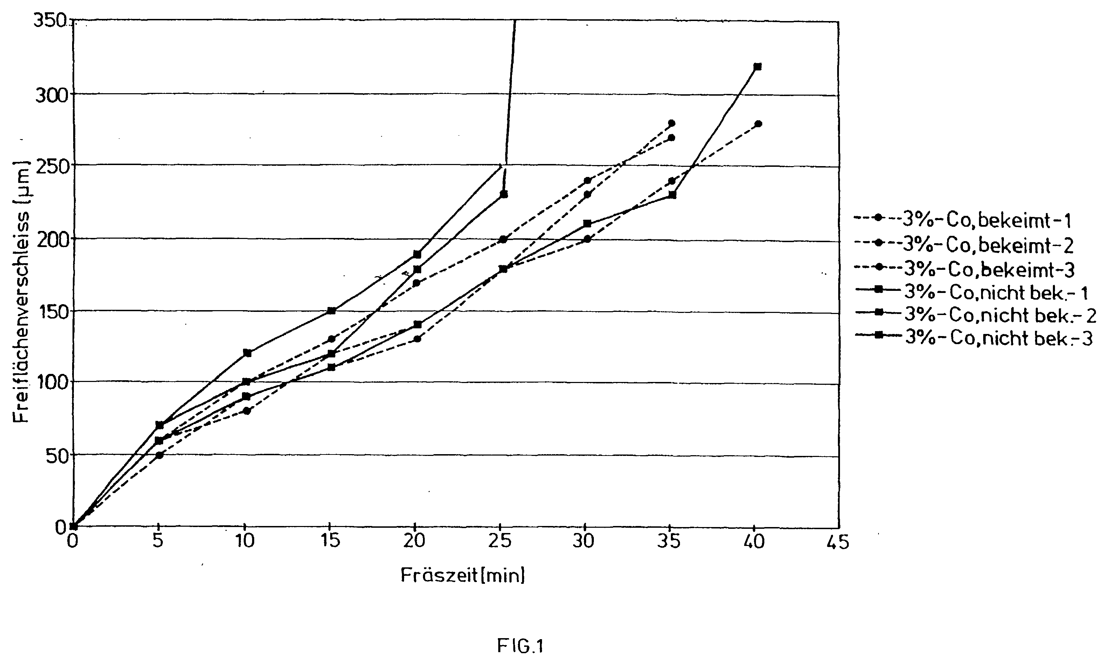

In Fig. 1 sind gestrichelt die bei einer Schnittgeschwindigkeit von 1200 m/min gemessenen Verläufe des "Freiflächenverschleisses in Funktion der Fräszeit" für erfindungsgemäss Diamantpulver-bekeimte Typ 3 %-Wendeschneidplatten dargestellt sowie für nicht erfindungsgemäss bekeimte Typ 3 %-Wendeschneidplatten, alle mit einer Diamantschicht von 20 µm Dicke beschichtet.

Es ist erkenntlich, dass offenbar die Häufigkeit von Schichtabplatzern bei nichtbekeimten Typ 3 %-Wendeschneidplatten bei den angegebenen Fräsbedingungen höher ist als bei den bekeimten.

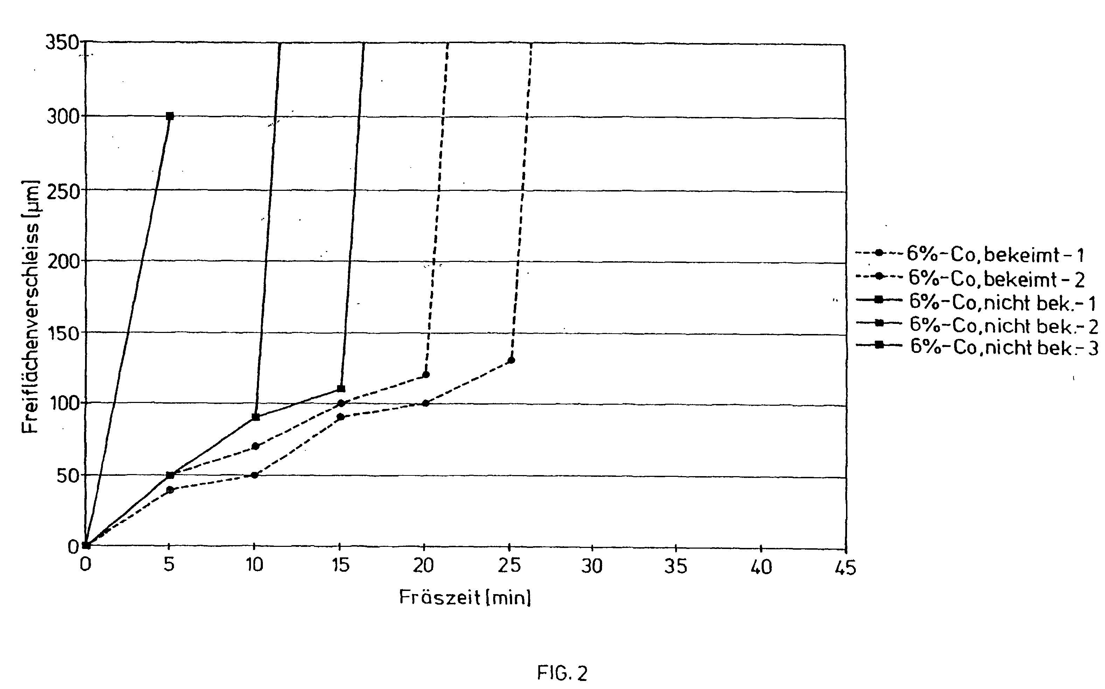

In Fig. 2 sind die Ergebnisse, analog den in Fig. 1 zusammengestellten, für zwei erfindungsgemäss bekeimte Wendeschneidplatten des Typs 6 % (gestrichtelt dargestellt) wiedergegeben sowie für drei nicht erfindungsgemäss Diamantpulver-bekeimte Typ 6 %-Wendeschneidplatten. Wiederum ist die Schnittgeschwindigkeit 1'200 m/Min., die Schichtdicke der Diamantschicht beträgt 20 µm.

Hier wird deutlich, dass die bekeimten Substrate höhere Standzeiten aufweisen, bis es zu Abplatzungen kommt.

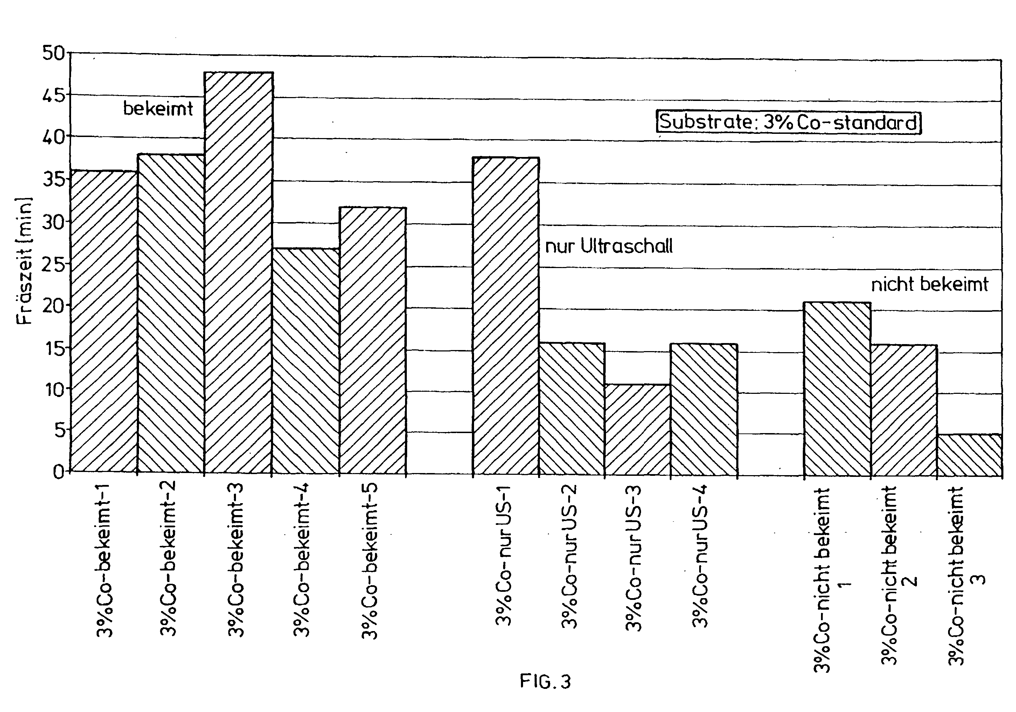

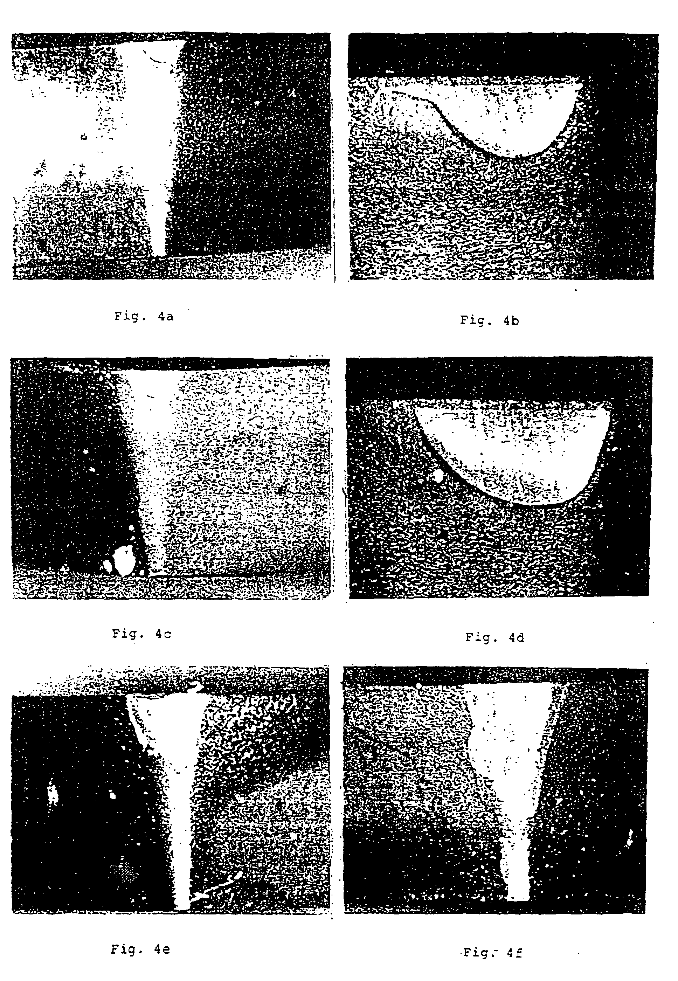

In Fig. 3 ist die Fräszeit bis zum Erreichen einer Verschleissmarkenbreite von 250 µm für bekeimte Typ 3 %-Wendeschneidplatten sowie für, wie oben angegeben, WC- und Kobalt-geätzte und, anstelle der Bekeimung, lediglich ultraschallgereinigter Typ 3 %-Wendeschneidplatten dargestellt, weiter für nichtbekeimte, nichtultraschallgereinigte Typ 3 %-Wendeschneidplatten. Die Schnittgeschwindigkeit betrug 1'500 m/Min., die Diamantbeschichtungs-Dicke war wiederum 20 µm. Die verbesserte Schichthaftung an den erfindungsgemäss behandelten Substraten ist deutlich. Während die bekeimten, erfindungsgemässen Substrate weitestgehend ein kontinuierliches Verschleissverhalten zeigten, bis zu grossen freigelegten Bereichen der Sintermetallcarbid-Oberfläche, traten insbesondere bei den weder bekeimten noch ultraschallgereinigten Substraten frühzeitig Schichtabplatzungen auf. Dies bestätigen die lichtmikroskopischen Untersuchungen gemäss den Fig. 4a bis 4d an den erfindungsgemäss bekeimten Wendeschneidplatten bei einer Vergrösserung von 20 (Figuren 4a, 4c, 4e) bzw. 80 (Figuren 4b, 4d, 4f), welche einen perfekten Schichtanschliff zeigen, während die unbekeimten gemäss den Fig. 4e und 4f ein klares Abplatzen der Diamantschicht vom Grundmaterial zeigen.

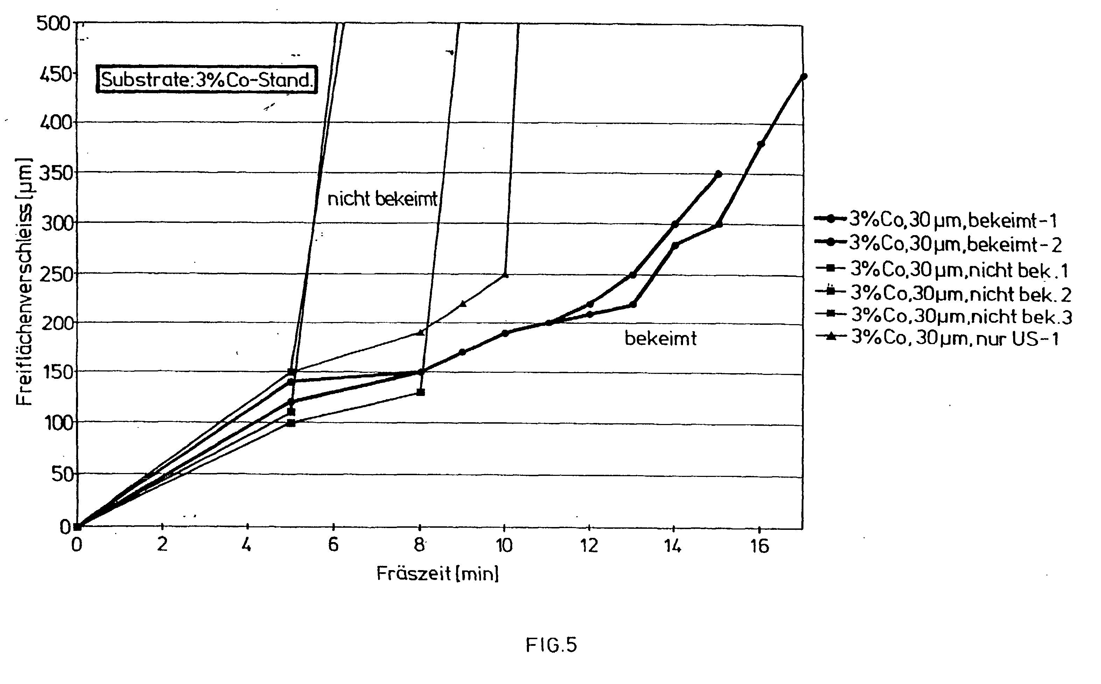

Fig. 5 zeigt einen Vergleich von Sandvik H∅5-Wendeschneidplatten, die einerseits erfindungsgemäss, anderseits, unter sonst gleichen Bedingungen, aber ohne Diamantpulver-Bekeimung vorbehandelt, und anschliessend mit einer 30 µm dicken Diamantschicht beschichtet wurden. Die Schnittgeschwindigkeit war 2'000 m/Min.

Die drei nicht bekeimten Wendeschneidplatten zeigen schon nach kurzen Schnittzeiten Schichtabplatzer. Das gleiche gilt, wenn auch in verringertem Masse, für die oben definierten, ätzbehandelten, nicht bekeimten, aber ultraschallbehandelten Wendeschneidplatten gemäss der Kurve -Δ-. Deutlich ist aber die wesentliche Verbesserung des Verschleissverhaltens an den erfindungsgemäss bekeimten Platten, dargestellt durch die dick ausgezogenen Kurven. Im Gegensatz zu den anderen Substraten, bei denen schon nach kurzer Fräszeit ein grossflächiges Abplatzen erkennbar ist, treten bei den erfindungsgemäss vorbehandelten Wendeschneidplatten keine Schichtabplat zungen auf (kontinuierliche Vergrösserung der Verschleissmarkenbreite).

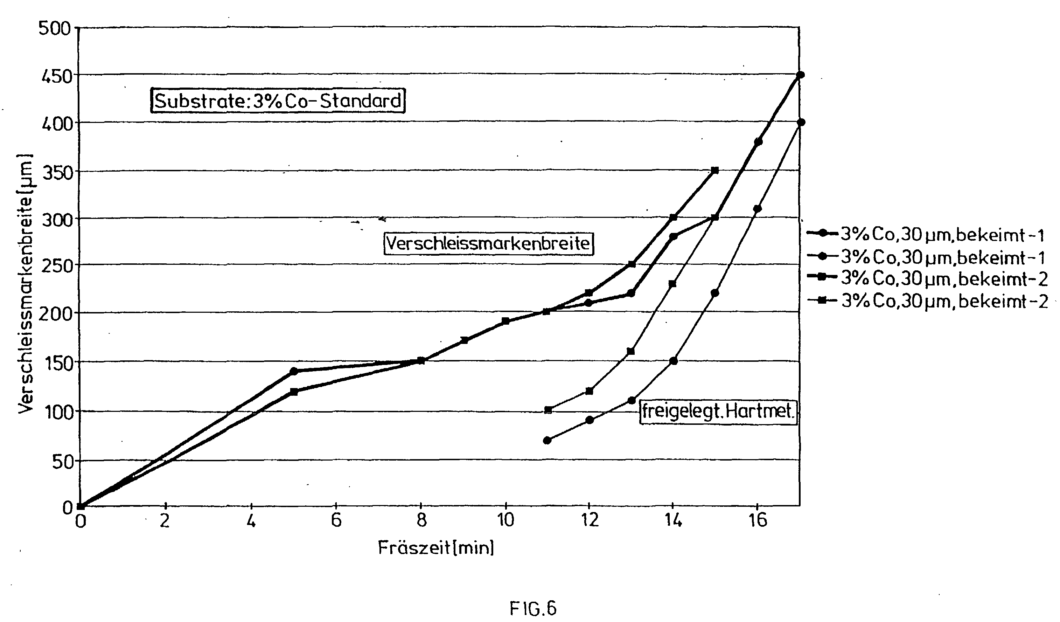

Schliesslich ist in Fig. 6 die Verschleissmarkenbreite sowie das Ausmass freigelegten Sintermetallcarbid-Materials bei erfindungsgemäss Diamantpulver-bekeimten Wendeschneidplatten in Funktion der Fräszeit, bei einer Schnittgeschwindigkeit von 2'000 m/Min. und mit einer 30 µm dicken Diamantschicht, gemäss Fig. 5 dargestellt.

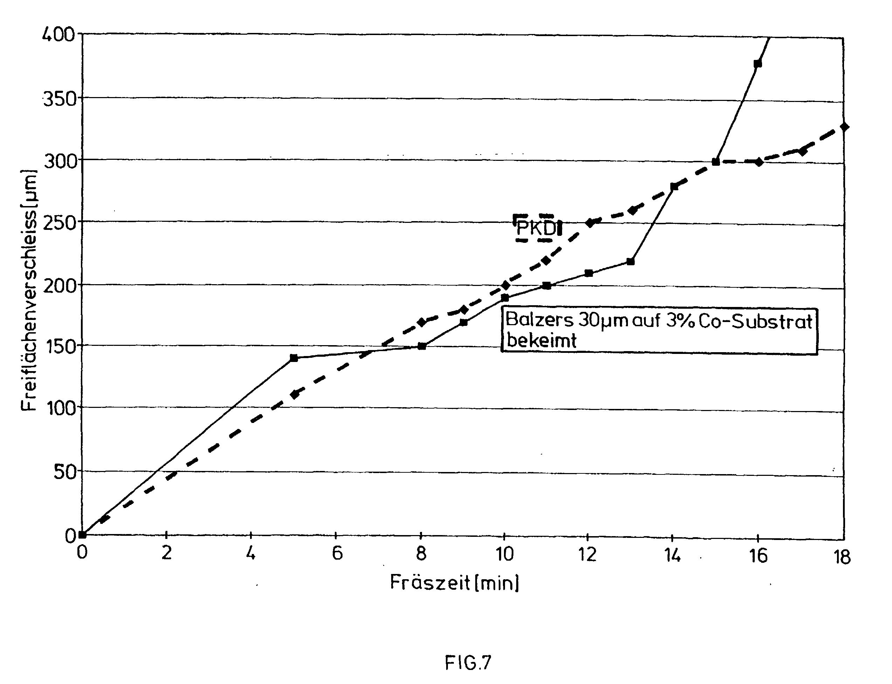

Fig. 7 zeigt den Freiflächenverschleiss in Funktion der Fräszeit an einer Typ 3 %-Wendeschneidplatte, erfindungsgemäs behandelt und mit einer Diamantschicht von 30 µm, im Vergleich zum Verhalten mit einer handelsüblichen polykristallin-diamant (PKD)-bestückten Platte. Daraus ist ersichtlich, dass erfindungsgemäss ein PKD-Platten-ähnliches Verschleissverhalten erreicht wird.

Der steilere Verschleissanstieg der erfindungsgemäss beschichteten Wendeschneidplatte nach einer Schnittzeit von 15 Min. ergibt sich nicht durch Schichtabplatzungen, sondern durch die wesentlich geringere Schichtdicke gegenüber PKD-Substraten.

Die vorliegenden Resultate zeigen, dass das Verschleissverhalten der erfindungsgemäss beschichteten Wendeschneidplatten, abhängig von den Testbedingungen (Schnittgeschwindigkeit) und, wie bekannt, vom Co-Gehalt des Substratmateriales gegenüber nichtbekeimten, sonst gleich behandelten, also insbesondere wie in der DE 19 522 372 bzw. der EP 0 519 587 prinzipiell behandelten Platten, wesentlich verbessert ist.

Wie bereits erwähnt, sind die chemischen Systeme zum selektiven WC-Ätzen bzw. zum selektiven Co-Ätzen z.B. aus den eingangs erwähnten Schriften vorbekannt, und die in den vorliegenden Beispielen eingesetzten Systeme dürften ohne weiteres durch andere der erwähnten, vorbekannten Systeme ersetzbar sein. Bezüglich Diamantbeschichtung sind ebenfalls viele Verfahren bekannt. Die vorliegende Erfindung ist weder auf die Durchführung der erwähnten Ätzschritte mit spezifischen chemischen Systemen beschränkt noch auf den Einsatz einer speziellen Diamantbeschichtungstechnik.

Eine weitere Verbesserung der Haftfestigkeit einer mittels CVD abgeschiedenen Diamantschicht ergibt sich, wenn zwischen dem Bekeimungsschritt, vorzugsweise im Ultraschallbad, und dem Beschichtungsprozess ein Prozessschritt vorgesehen ist, in dem die zu beschichtenden Substrate einer Ultraschall-Behandlung in einer Flüssigkeit (Dl-Wasser, Alkohole, od. Ähnliches) ausgesetzt werden, um nur lose auf der Oberfläche haftende Diamantpartikel zu entfernen. Bei Bedarf können der Flüssigkeit auch noch geringe Mengen eines Netzmittels beigefügt werden, um anschliessend ein besseres Ablaufen und Trocknen zu ermöglichen. Durch diesen Behandlungsschritt bleiben nur noch die in den durch das vorhergehende Ätzen erzeugten Löchern bzw. Rauhigkeiten gut verankerten Diamantpartikel auf der Oberfläche zurück, was eine noch weitere Verbesserung der Haftung der Diamantschicht bewirken dürfte. Besonders vorteilhaft wirkt sich dies dann aus, wenn diese Behandlung zu einem Verfahrensablauf WC-Ätzen - Co-Ätzen - Bekeimen - Ultraschall-Behandlung - Beschichten kombiniert wird.

Das erfindungsgemässe Verfahren eignet sich insbesondere für die Herstellung von Werkzeugen, insbesondere von spanabhebenden, wie von Fräsern, Bohrern, Wendeschneidplatten oder von Maschinenbauteilen, wie Lagerschalen und Wellen.

## Patentansprüche

1. Verfahren zum Beschichten von Sintermetallcarbid-Substraten mit einer Diamantschicht, bei dem das Substrat vor der Diamantbeschichtung einem WC-selektiven Ätzschritt und einem Co-selektiven Ätzschritt unterzogen wird und weiter einer Bekeimung durch Kontakt mit Diamantpulver, darnach, auf einem gewünschten Abschnitt des Substrates, eine Diamantschicht abgelegt wird,
**dadurch gekennzeichnet, dass** beide selektiven Ätzschritte vor oder mindestens einer davon gleichzeitig mit dem Bekeimungsschritt durchgeführt werden.

2. Verfahren nach Anspruch 1, **dadurch gekennzeichnet, dass** eine der folgenden Schrittreihenfolgen eingehalten wird:
(a) - selektives Co-Ätzen,
- selektives WC-Ätzen,
- Diamantpulver-Bekeimen,
- Diamantbeschichten;
oder, und bevorzugt,
(b) - selektives WC-Ätzen,
- selektives Co-Ätzen,
- Diamantpulver-Bekeimen,
- Diamantbeschichten.

3. Verfahren nach einem der Ansprüche 1 oder 2, **dadurch gekennzeichnet, dass** die Diamantpulver-Bekeimung in einem Ultraschallbad erfolgt.

4. Verfahren nach Anspruch 3, **dadurch gekennzeichnet, dass** das Flüssigmedium des Ultraschallbades gleichzeitig ein chemisches System für einen der erwähnten, selektiven Ätzschritte ist, vorzugsweise für den selektiven Co-Ätzschritt.

5. Verfahren nach einem der Ansprüche 1 bis 4, **dadurch gekennzeichnet, dass** man die Substrate nach dem Bekeimen und vor dem Beschichten in einer Flüssigkeit spült, vorzugsweise in einem Ultraschallbad, wobei vorzugsweise die Flüssigkeit ein Netzmittel enthält.

6. Verwendung des Verfahrens nach einem der Ansprüche 1 bis 5 für die Herstellung von Werkzeugen, insbesondere von spanabhebenden Werkzeugen, wie Fräser, Bohrer, Wendeschneidplatten oder von Maschinenbauteilen, wie Lagerschalen, Wellen.

## Claims

1. Process for coating sintered metal carbide substrates with a diamond coating in which, before the diamond coating, the substrate is subjected to a WC-selective etching step and a Co-selective etching step and further to seeding by contact with diamond powder, thereafter on a desired section of the substrate a diamond coating is deposited, **characterised in that** the two selective etching steps are performed before or at least one step at the same time as the seeding step.

2. Process according to claim 1 **characterised in that** one of the following step sequences is observed:
(a) - selective Co-etching;
- selective WC-etching;
- diamond powder seeding;
- diamond coating;
or, and preferably,
(b) - selective WC-etching;
- selective Co-etching;
- diamond powder seeding;
- diamond coating.

3. Process according to either of claims 1 or 2 **characterised in that** the diamond powder seeding takes place in an ultrasound bath.

4. Process according to claim 3 **characterised in that** the liquid medium of the ultrasound bath is simultaneously a chemical system for one of the said selective etching steps, preferably the selective Co-etching step.

5. Process according to any of claims 1 to 4, **characterised in that** after seeding and before coating, the substrate is rinsed in a fluid, preferably in an ultrasound bath, where preferably the fluid contains a wetting agent.

6. Use of the process according to any of claims 1 to 5 for the production of tools, in particular cutting tools such as milling cutters, drills, indexable inserts, or machine components such as bearing shells, shafts.

## Revendications

1. Procédé pour revêtir d'une couche diamantée, des substrats de carbure métallique fritté, dans lequel le substrat, avant application de la couche diamantée, est soumis à une étape d'attaque sélective de WC et à une étape d'attaque sélective de Co, et en outre à un ensemencement par contact avec une poudre de diamant, puis dépôt d'une couche diamantée, sur une partie souhaitée du substrat,
**caractérisé en ce que** les deux étapes d'attaque sélective sont mises en oeuvre avant l'étape d'ensemencement, ou au moins l'une d'entre-elles est mise en oeuvre en même temps que l'étape d'ensemencement.

2. Procédé selon la revendication 1, **caractérisé en ce que** l'on respecte l'une des séquences suivantes d'étapes :
(a) - attaque sélective de Co,
- attaque sélective de WC,
- ensemencement par une poudre de diamant,
- application d'une couche diamantée ;
- ou, et de préférence
(b) - attaque sélective de WC,
- attaque sélective de Co,
- ensemencement par une poudre de diamant,
- application d'une couche diamantée.

3. Procédé selon l'une des revendications 1 et 2, **caractérisé en ce que** l'ensemencement par une poudre de diamant s'effectue dans un bain à ultrasons.

4. Procédé selon la revendication 3, **caractérisé en ce que** le milieu liquide du bain à ultrasons est simultanément un système chimique pour l'une des étapes mentionnées d'attaque sélective, de préférence pour l'étape d'attaque sélective de Co.

5. Procédé selon l'une des revendications 1 à 4, **caractérisé en ce que**, après ensemencement et avant application en revêtement, on rince les substrats dans un liquide, de préférence dans un bain à ultrasons, le liquide contenant de préférence un mouillant.

6. Utilisation du procédé selon l'une des revendications 1 à 5 pour fabriquer des outils, en particulier des outils d'usinage, tels que des fraises, des forets, des plaquettes amovibles, ou encore des composants de machines, tels que des coquilles de coussinets et des arbres.
